# EUROPÄISCHE PATENTSCHRIFT

(11) **EP 3 017 479 B1**
(45) Veröffentlichungstag und Bekanntmachung des Hinweises auf die Patenterteilung: **13.07.2022**
(21) Anmeldenummer: 14724710.0
(22) Anmeldetag: 13.05.2014
(51) Int. Cl.: H01L 29/78, H01L 29/40, H01L 29/06

(54) **FELDPLATTEN-TRENCH-FET SOWIE EIN HALBLEITERBAUELEMENT**
TRENCH FIELD PLATE FET AND SEMICONDUCTOR DEVICE
FET À PLAQUE DE CHAMP ET TRANCHÉE ET DISPOSITIF SEMI-CONDUCTEUR

(30) Priorität: 03.07.2013 DE 102013213026
(43) Veröffentlichungstag der Anmeldung: 11.05.2016
(73) Patentinhaber: Robert Bosch GmbH, 70442 Stuttgart (DE)
(72) Erfinder: HOEHR, Timm, 72762 Reutlingen (DE); LIPSKI, Frank, 72762 Reutlingen (DE); MARTINI, Ingo, 72766 Reutlingen (DE); TOLKSDORF, Carolin, 72294 Groembach (DE)
(86) Internationale Anmeldenummer: PCT/EP2014/059703
(87) Internationale Veröffentlichungsnummer: WO 2015/000619

(56) Entgegenhaltungen:
- DE-A1-102010 063 314
- JP-A- H 057 002
- US-A1- 2008 258 208
- US-A1- 2009 189 219
- US-A1- 2011 227 149
- US-A1- 2012 153 386

## Beschreibung

Die vorliegende Erfindung betrifft ein Halbleiterbauelement mit einer Vielzahl an Feldplatten-Trench-FETs, welche ein Substrat, ein zumindest teilweise innerhalb des Substrates vergrabenes Gate, und ein unterhalb des Gates angeordnete Feldplatte umfassen, wobei sowohl das Gate als auch die Feldplatte innerhalb eines Grabens im Substrat angeordnet und von einem Isolator umschlossen sind.

### Stand der Technik

Leistungstransistoren kommen heutzutage in einer Vielzahl von Anwendungen zum Einsatz. Insbesondere sogenannte Trench-FETs, also Feldeffekt-Transistoren, deren Aufbau beziehungsweise deren sogenanntes Trench-Gate im Wesentlichen innerhalb eines Grabens realisiert ist und deren Kanal in vertikaler Richtung entlang dieses Trench-Gates verläuft, erfreuen sich einer zunehmenden Beliebtheit. In jüngster Zeit kommen dabei vermehrt sogenannte Feldplatten-Trench-FETs zum Einsatz, welche innerhalb des Grabens und unterhalb des Gates eine vertikal, also eine parallel zur Tiefe des Grabens angeordnete Feldplatte aufweisen.

Beim Abschalten solcher Feldplatten-Trench-FETs gehen selbige bei Vorliegen bestimmter Bedingungen in den Zustand des Lawinendurchbruchs über, das heißt mit anderen Worten ausgedrückt, es kommt bei den Transistoren zu dem Phänomen des sogenannten Avalanche-Durchbruchs. Dies wird in der Regel durch eine hohe Induktivität im sogenannten Kommutierkreis eines jeweiligen Feldplatten-Trench-FETs erzwungen. Das Maximum des vorherrschenden elektrischen Feldes im Halbleiter sowie der Ort beziehungsweise die Orte des Durchbruchs liegen im Falle eines solchen Lawinendurchbruchs jeweils am unteren Ende des Grabens des Feldplatten-Trench-FETs in Bereichen, welche sich seitlich des Grabens des Feldplatten-Trench-FETs befinden.

Im Falle eines Lawinendurchbruchs innerhalb solcher Transistoren kann die räumliche Nähe des Maximums der Stoßionisation beziehungsweise die räumliche Nähe der bei dieser Stoßionisation generierten Löcher zu den Gate- oder Feldoxiden zu einer Einlagerung der genannten Ladungsträger in die Oxide oder zu einer Schädigung der Oxide und deren Oberflächen durch im Feld beschleunigte Ladungsträger führen. Die Einlagerung der Ladungsträger in die Oxide wird auch als "Charge Trapping" bezeichnet. Bei häufig wiederkehrenden Durchbruchsereignissen können diese eine Degradation der Sperrspannung des Transistors bewirken und schließlich zu einem Ausfall des Bauelements führen. Für Anwendungen in denen wiederholte Durchbruchsereignisse auftreten, sind daher Bauelemente von Vorteil, bei denen entsprechende Ladungsträger nicht in direkter Nähe zu den Oxiden generiert werden.

Im Stand der Technik wird ein solches Charge Trapping" durch die Verwendung planarer Bauelemente vermieden, bei denen der Durchbruch im Silizium am PN-Übergang, also vom sogenannten Transistor-Body beziehungsweise dem Bulk des Transistors, zu einer niedrig dotierten Driftzone hin stattfindet, sodass die betreffenden Ladungsträger die an der Oberfläche liegenden Oxide nicht erreichen. Diese planaren Bauelemente weisen jedoch gegenüber Trench-FETs - bei gleicher aktiver Chipfläche A - einen größeren Widerstand der Drain-Source Strecke auf, welcher auch als Ron bezeichnet wird. Das Produkt aus Ron und A solcher planaren Transistoren ist also größer als bei Trench-FETs.

Ein besonders geringes Produkt aus Ron und A wird durch oben genannte Trench-MOSFETs mit Kompensationselektroden erreicht.

Die US 2008/0258208 A1 beschreibt ein Halbleiterbauelement mit einer Vielzahl an einen Graben aufweisenden MOSFETS, welche jeweils eine innerhalb des Grabens und innerhalb eines Isolators eingefasste Feldplatte sowie jeweils eine Kompensationszone unterhalb ihres Grabens aufweisen.

Die US 2012/0153386 A1 offenbart ein Halbleiterbauelement mit einer Vielzahl an Feldplatten-Trench-FETs, wobei die Feldplatten innerhalb von Gräben angeordnet sind, die sich wiederum innerhalb einer n-dotierten Halbleiterzone befinden. Unterhalb der Feldplatten-Trench-FETs ist jeweils eine p-dotiere Zone angeordnet.

Die DE 10 2010 063 314 A1 offenbart eine Halbleiteranordnung, weiche ein auf einem als Kathode dienenden n⁺-Substrat aufgebrachtes n-dotiertes Gebiet aufweist, an welchem eine p-dotierte Schicht angebracht ist, an deren Oberfläche sich hoch p+-dotierte Schichten und hoch n⁺-dotierte Schichten befinden und in welcher sich mindestens zwei mit p-dotiertem Polysilizium gefüllte und mit Oxidschichten bedeckte eingeätzte Gräben befinden, wobei im n-dotierten Gebiet im Bereich des Bodens der Gräben oder zwischen den Gräben p-dotierte Schichten vorgesehen sind.

Die JP H05 7002 A beschreibt eine Vielzahl von jeweils einen Graben aufweisende Funktionselemente innerhalb eines Halbleiter-Bauelementes, wobei unterhalb zumindest einiger der Funktionselemente jeweils ein p-dotiertes Gebiet angeordnet ist.

### Offenbarung der Erfindung

Erfindungsgemäß wird ein Halbleiterbauelement nach Anspruch 1 zur Verfügung gestellt. Mit einem solchen Halbleiterbauelement ist die mit der Verwendung eines erfindungsgemäßen Feldplatten-Trench-FETs einhergehende Vorteilhaftigkeit auf das ganze Halbleiterbauelement beziehungsweise ferner sogar auf einen ganzen Chip ausdehnbar. Bevorzugte Ausführungsformen sind in den abhängigen Ansprüchen definiert. Jede Ausführungsform/jeder Aspekt/jede Konfiguration/jedes Beispiel/jede Variante, die nicht alle Merkmale des Anspruchs 1 aufweist, gehört nicht zur Erfindung, kann aber als nützlich für das Verständnis der vorliegenden Erfindung angesehen werden.

Das Halbleiterbauelementes umfasst ferner mindestens einen Trench-FET, welcher ein Substrat sowie zumindest ein teilweise innerhalb des Substrates vergrabenes Gate umfasst, wobei das Gate innerhalb eines Grabens angeordnet und von einem Isolator umschlossen ist. Mit anderen Worten ausgedrückt, weist das Halbleiterbauelement ferner bevorzugt mindestens einen Trench-FET des Standes der Technik ohne ein p-dotiertes Gebiet auf.

Die Feldplatten-Trench-FETs umfassen ein Substrat, ein zumindest teilweise innerhalb des Substrates vergrabenes Gate und eine unterhalb des Gates angeordnete Feldplatte, wobei sowohl das Gate als auch die Feldplatte innerhalb eines Grabens im Substrat angeordnet und von einem Isolator umschlossen sind. Unterhalb des Grabens ist ein p-dotiertes Gebiet innerhalb des Substrats angeordnet. Erfindungsgemäß ist das p-dotierte Gebiet elektrisch leitfähig mit der Feldplatte verbunden und ist das p-dotierte Gebiet über einen elektrisch leitfähigen Pfad durch den innerhalb des Grabens befindlichen Isolator mit der Feldplatte elektrisch leitfähig verbunden.

Der Vorteil eines derartigen Feldplatten-Trench-FET ist, dass im Durchbruchsfall desselben das Maximum der Stoßionisation vom Trench-Boden, also vom Boden des Grabens, ferngehalten wird. Dieses Maximum beziehungsweise der Ort des Durchbruchs befindet sich stattdessen im unteren Bereich des pn-Übergangs des p-dotierten Gebiets. Dadurch werden die Einlagerung von Ladungsträgern und die Drift des Bauelementes, also die kontinuierliche Veränderung von wichtigen Parametern wie der Durchbruchspannung und der Einsatzspannung des Bauelements bezogen auf deren jeweiligen Nominalwerte, verhindert beziehungsweise reduziert.

Mit anderen Worten ausgedrückt, liegt das p-dotierte Gebiet bevorzugt auf dem elektrischen Potenzial der Feldplatte des Feldplatten-Trench-FETs. In einem derartigen Ausführungsbeispiel ist der Bereich des Avalanche-Durchbruchs sicherer vom Boden des Grabens weg an den pn-Übergang zwischen Substrat und p-Gebiet verlagert.

Eine solche elektrisch leitfähige Verbindung zwischen dem p-Gebiet und der Feldplatte ist besonders einfach über verschiedene Ätzverfahren realisierbar.

Bevorzugt weist das Halbleiterbauelement eine Vielzahl von Trench-FETs auf, wobei jeweils ein Trench-FET direkt neben einem erfindungsgemäßen Feldplatten-Trench-FET angeordnet ist. Bei derart ausgeführten Halbleiterbauelementen ist der Durchbruchsort bei einem Großteil der Feldplatten-Trench-FETs an die p-Gebiete der erfindungsgemäß ausgeführten Feldplatten-Trench-FETs gebunden. Gegenüber einer Ausführungsform mit jeweils einem p-Gebiet unter jedem Feldplatten-Trench-FET ist zudem das Produkt aus Ron und A, also aus dem Widerstand der Drain-Source-Strecke des Feldplatten-Trench-FETs und der aktiven Fläche A des Halbleiterbauelementes über das gesamte Halbleiterbauelement betrachtet, reduziert.

Außerdem wechselt sich jeweils eine Reihe aus nebeneinander angeordneten Trench-FETs mit einer Reihe aus nebeneinander angeordneten erfindungsgemäßen Feldplatten-Trench-FETs ab, wobei zumindest einige der p-dotierten Gebiete der innerhalb jeweils einer Reihe angeordneten erfindungsgemäßen Feldplatten-Trench-FETs miteinander zu einem sich innerhalb des Substrates des Halbleiterbauelementes erstreckenden Streifen verbunden sind. Mit anderen Worten ausgedrückt, sind innerhalb der Reihen aus nebeneinander angeordneten erfindungsgemäßen Feldplatten-Trench-FETs jeweils zumindest einige der diesen zugehörigen p-dotierten Gebiete bevorzugt miteinander zu einem Streifen aus einem zusammenhängenden p-dotierten Gebiet verbunden. Diese Streifen erstrecken sich jeweils bevorzugt senkrecht zur Ausbreitungsrichtung der sich in die Tiefe des Halbleiterbauelementes erstreckenden Gräben der Feldplatten-Trench-FETs. Die Streifen verlaufen also bevorzugt parallel zur Oberfläche des Halbleiterbauelements. Über derartige Ausführungsformen kann genau eingestellt werden, bei wie vielen beziehungsweise weichen Transistoren eine Maßnahme zur Verlagerung des Durchbruchortes vorgenommen beziehungsweise bei wie vielen Transistoren auf die Vornahme derartiger Maßnahmen zwecks Steigerung des Produktes aus dem Drain-Source-Widerstand Ron und der aktiven Fläche A des Halbleiterbauelementes verzichtet wird.

In einer bevorzugten Weiterentwicklung einer der zuvor genannten Ausführungsformen weist mindestens einer der Trench-FETs eine innerhalb seines jeweiligen Grabens angeordnete Feldplatte auf und ist der mindestens eine Trench-FET als Feldplatten-Trench-FET ausgeführt. Mit anderen Worten ausgedrückt, ist bevorzugt mindestens einer der Trench-FETs des Standes der Technik als Feldplatten-Trench-FET ausgeführt, ohne eine p-Dotierung beziehungsweise ein p-dotiertes Gebiet unterhalb seines zugehörigen Grabens aufzuweisen. Bei mehreren als Feldplatten-Trench-FETs des Standes der Technik ausgeführten Trench-FETs des Standes der Technik weisen bevorzugt zumindest einige dieser Feldplatten-Trench-FETs des Standes der Technik jeweils eine Feldplatte auf, welche ihrer Länge nach gemessen kürzer ist als die Feldplatte desjenigen erfindungsgemäßen Feldplatten-Trench-FETs des erfindungsgemäßen Halbleiterbauelementes mit der der Länge nach gemessen kürzesten Feldplatte. In einer bevorzugten Weiterentwicklung dieser Ausführungsform weisen zumindest einige derjenigen Feldplatten-Trench-FETs des Standes der Technik mit den kürzeren Feldplatten und/oder einige der Trench-FETs des Standes der Technik ohne Feldplatte jeweils einen Graben auf, welcher eine geringere Tiefe als der Graben des erfindungsgemäßen Feldplatte-Trench-FET des erfindungsgemäßen Halbleiterbauelementes mit der geringsten Tiefe aufweist.

In einer bevorzugten Ausführungsform ist der Feldplatten-Trench-FET als Feldplatten-Trench-MOSFET ausgeführt. Feldplatten-Trench-MOSFETs sind kostengünstig und sehr kompakt, das heißt in einer hohen Integrationsdichte realisierbar. Ferner weisen Feldplatten-Trench-MOSFETS eine schnelle Schaltzeit sowie stabile Verstärkungs- und Antwortzeiten auf.

Bevorzugt ist das Substrat als Halbleiterschicht ausgeführt. Ferner bevorzugt befindet sich unterhalb der Halbleiterschicht ein weiteres Substrat. Des Weiteren bevorzugt ist das weitere Substrat unterhalb der Halbleiterschicht hochdotiert.

In einer ferner bevorzugten Ausführungsform weisen die Gräben zumindest einiger der Trench-FETs des Standes der Technik jeweils eine Tiefe auf, welche geringer ist als die Tiefe desjenigen Grabens desjenigen erfindungsgemäßen Feldplatten-Trench-FETs des erfindungsgemäßen Halbleiterbauelementes mit der geringsten Tiefe.

In einer bevorzugten Weiterentwicklung einer der vorhergehenden Ausführungsformen weisen die Gräben zumindest einiger der als Feldplatten-Trench-FETs des Standes der Technik ausgeführten Trench-FETs jeweils eine Tiefe auf, die geringer ist als die jeweilige Tiefe der Gräben eines oder aller der diesen Feldplatten-Trench-FETs des Standes der Technik jeweils direkt benachbarten erfindungsgemäßen Feldplatten-Trench-FETs des erfindungsgemäßen Halbleiterbauelementes.

In einer des Weiteren bevorzugten Ausführungsform weist das Halbleiterbauelement mindestens zwei Trench-FETs des Standes der Technik und mindestens zwei erfindungsgemäße Feldplatten-Trench-FETs auf, wobei die Trench-FETs des Standes der Technik und die erfindungsgemäßen Feldplatten-Trench-FETs beliebig zueinander innerhalb des Halbleiterbauelementes angeordnet sind.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen:
Figur 1 eine Gegenüberstellung von einem Halbleiterbauelement des Standes der Technik und einem ersten Ausführungsbeispiel eines Halbleiterbauelementes,
Figur 2 ein zweites und ein drittes Ausführungsbeispiel von Halbleiterbauelementen,
Figur 3 ein viertes Ausführungsbeispiel eines Halbleiterbauelementes,
Figur 4 drei verschiedene schematisch dargestellte Beispiele die nicht Bestandteil der Erfindung sind sowie ein Ausführungsbeispiel eines Layouts für die Anordnung von Feldplatten-Trench-FETs innerhalb erfindungsgemäß ausgeführter Halbleiterbauelemente in einer Draufsicht,
Figur 5 zwei weitere schematisch dargestellte Ausführungsbeispiele von Layouts für die Anordnung von Feldplatten-Trench-FETs innerhalb erfindungsgemäß ausgeführter Halbleiterbauelemente in einer Draufsicht, und
Figur 6 drei weitere schematisch dargestellte Ausführungsbeispiele von Layouts für die Anordnung von Feldplatten-Trench-FETs innerhalb ausgeführter Halbleiterbauelemente in einer Draufsicht.

### Ausführungsformen der Erfindung

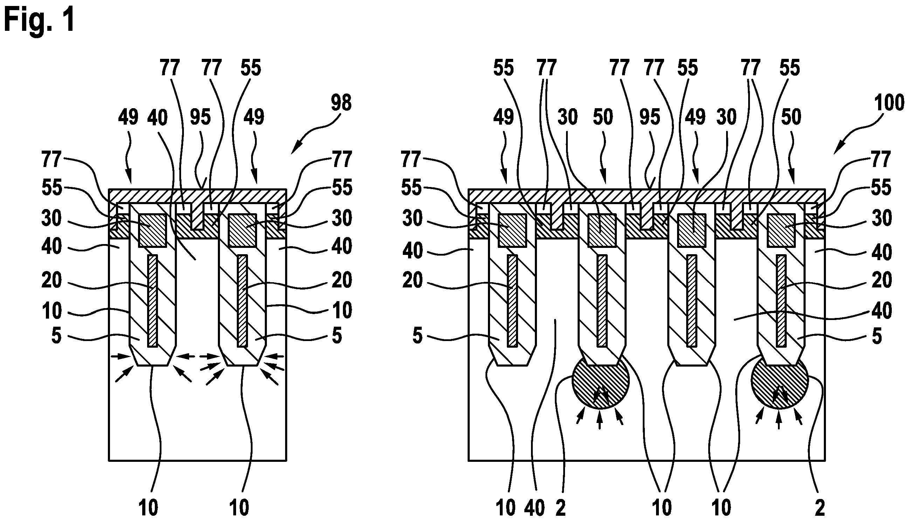

In der Figur 1 ist eine Gegenüberstellung von einem Halbleiterbauelement des Standes der Technik 98 mit einem ersten Ausführungsbeispiel eines Halbleiterbauelementes 100 gezeigt. Sowohl das Halbleiterbauelement 98 des Standes der Technik als auch das erste Ausführungsbeispiel eines Halbleiterbauelementes 100 sind dabei jeweils in einem Querschnitt dargestellt. Das in Figur 1 links gezeigte Halbleiterbauelement des Standes der Technik 98 umfasst zwei

Feldplatten-Trench-FETs des Standes der Technik 49, welche jeweils ein Substrat 40, ein in diesem Ausführungsbeispiel rein beispielhaft vollständig innerhalb des Substrates 40 vergrabenes Gate 30 sowie jeweils eine unterhalb des jeweiligen Gates 30 der Feldplatten-Trench-FETs des Standes der Technik 49 angeordnete Feldplatte 20 aufweisen. Sowohl das Gate 30 als auch die Feldplatte 20 sind jeweils innerhalb eines Grabens 10 im Substrat 40 der jeweiligen Feldplatten-Trench-FETs des Standes der Technik 49 angeordnet und jeweils von einem Isolator 5 umschlossen. Der Isolator 5 ist in diesem Ausführungsbeispiel rein beispielhaft als Oxid ausgeführt. Ferner ist in Figur 1 die Oberfläche 95 des Halbleiterbauelementes des Standes der Technik 98 eingezeichnet. Unterhalb der Gräben 10 der Feldplatten-Trench-FETs des Standes der Technik 49 ist links in Figur 1 über Pfeile auf die Bereiche, Stellen beziehungsweise Gebiete verwiesen, in welchen es im Falle eines Avalanche-Durchbruchs beziehungsweise im Falle eines Lawinendurchbruchs unterhalb der Gräben 10 der Feldplatten-Trench-FETs des Standes der Technik 49 jeweils zum Durchbruch kommt. Mit anderen Worten ausgedrückt, sind links in Figur 1 über Pfeile die Bereiche gezeigt, in weichen im Falle eines Lawinendurchbruchs das Maximum der Stoßionisation der Ladungsträger liegt beziehungsweise bei welchen es zu einem Charge Trapping, also zu einer unerwünschten Einlagerung von Ladungsträgern in den Isolator 5 beziehungsweise in das Oxid, welches hier rein beispielhaft als Feldoxid ausgeführt ist, kommen kann. In diesem Beispiel sind die Gräben 10 der Feldplatten-Trench-FETs des Standes der Technik 49 rein beispielhaft senkrecht zur Oberfläche 95 des Halbleiterbauelementes des Standes der Technik 98 in das Substrat 40 desselben eingelassen beziehungsweise geätzt.

Das rechts in Figur 1 dargestellte erste Ausführungsbeispiel eines Halbleiterbauelementes 100 weist eine Vielzahl an Feldplatten-Trench-FETs 50, 49 auf, von denen rechts in Figur 1 vier dargestellt sind. Von diesen vier dargestellten Feldplatten-Trench-FETs 50, 49 sind in diesem ersten Ausführungsbeispiel der erste und dritte, von links ausgehend betrachtet, wie zuvor beschrieben ausgeführte Feldplatten-Trench-FETs des Standes der Technik 49, während es sich bei dem zweiten sowie dem vierten Feldplatten-Trench-FET 50, von links ausgehend betrachtet, um Ausführungsbeispiele Feldplatten-Trench-FETs 50 handelt.

Mit anderen Worten ausgedrückt, umfasst das rechts in Figur 1 dargestellte Ausführungsbeispiel eines Halbleiterbauelementes 100 eine Vielzahl an Feldplatten-Trench-FETs 50, 49, wobei jeweils ein nicht erfindungsgemäß ausgeführter Feldplatten-Trench-FET des Standes der Technik 49 direkt neben einem unterschiedlich ausgeführten Feldplatten- Trench-FET 50 angeordnet ist.

Die gleich bezeichneten Komponenten links in Figur 1 entsprechen dabei jenen des ersten Ausführungsbeispiels rechts in Figur 1, sodass das zuvor beschriebene also auch auf das rechts in Figur 1 dargestellte erste Ausführungsbeispiel zu übertragen ist. Der wesentliche Unterschied zwischen dem links in Figur 1 dargestellten Halbleiterbauelement des Standes der Technik 98 und dem rechts dargestellten ersten Ausführungsbeispiel ist darin gegeben, dass die ausgeführten Feldplatten-Trench-FETs 50 jeweils ein p-dotiertes Gebiet 2 unterhalb ihres jeweiligen Grabens 10 innerhalb des Substrats 40 aufweisen. Mit anderen Worten ausgedrückt, ist unterhalb der Gräben 10 der beiden ausgeführten Feldplatten-Trench-FETs 50 jeweils ein p-dotiertes Gebiet 2 vorgesehen, welche in diesem ersten Ausführungsbeispiel jeweils an die Gräben 10 ihrer jeweils zugehörigen Feldplatten-Trench-FETs 50 angrenzen. Die p-dotierten Gebiete 2 erstrecken sich jeweils unterhalb der Gräben 10 ihrer jeweils zugehörigen Feldplatten-Trench-FETs 50. Für die ausgeführten Feldplatten-Trench-FETs 50 ist ebenfalls über Pfeile auf die Bereiche, Stellen beziehungsweise Gebiete verwiesen, in welchen es im Falle eines Avalanche-Durchbruchs beziehungsweise im Falle eines Lawinendurchbruchs jeweils zum Durchbruch kommt. Die Gebiete, in welchen es zu einem Durchbruch kommt, sind bei diesen Feldplatten-Trench-FETs 50 von den Böden der Gräben 10 entfernt beziehungsweise distanziert.

Bei den p-dotierten Gebieten 2 der Feldplatten-Trench-FETs 50 handelt es sich in diesem ersten Ausführungsbeispiel rein beispielhaft um innerhalb des Substrates 40 floatende, also potenzialfreie Gebiete, welche anders formuliert nicht mit einem konstanten beziehungsweise festen Potenzial verbunden sind. In diesem ersten Ausführungsbeispiel sind sowohl die Gates 30, als auch die Feldplatten 20 und das Substrat 40 der Feldplatten-Trench-FETs 50, 49 rein beispielhaft n-dotiert. Die genannten Komponenten können in anderen erfindungsgemäß ausgeführten Halbleiterbauelementen 100 allerdings auch anders dotiert sein. Ferner weisen die Feldplatten-Trench-FETs 50, 49 des Halbleiterbauelementes 100 in diesem Ausführungsbeispiel jeweils ein Source-Gebiet 77 sowie ein Body-Gebiet 55 auf, welche unter anderem der Ansteuerung der Feldplatten-Trench-FETs 50, 49 dienen.

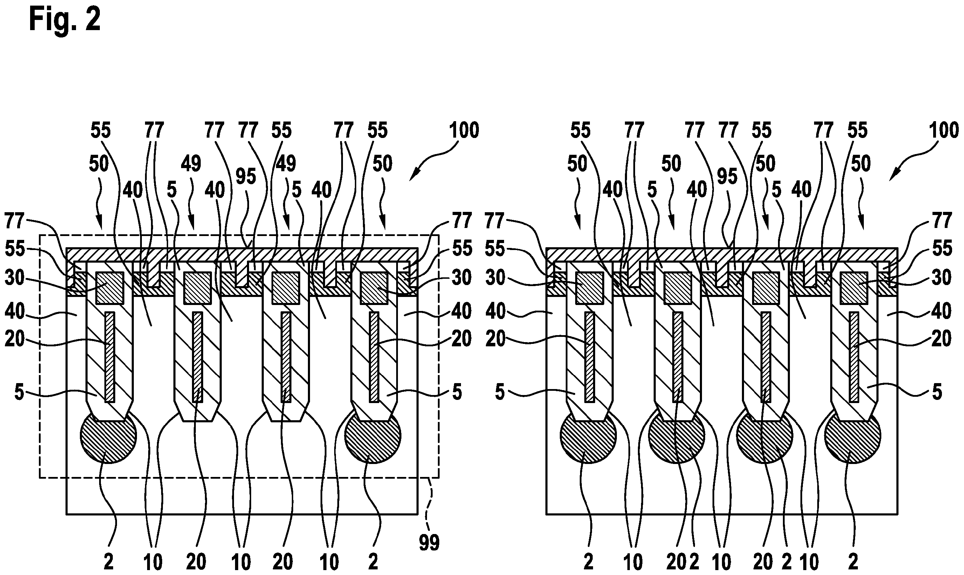

In Figur 2 sind ein zweites und ein drittes Ausführungsbeispiel von Halbleiterbauelementen 100 gezeigt. Die gleich bezeichneten Komponenten in Figur 2 entsprechen dabei jenen des ersten Ausführungsbeispiels der Figur 1, sodass das dort Beschriebene bezüglich dieser Komponenten auch auf das zweite und dritte Ausführungsbeispiel der Figur 2 zu übertragen ist. Sowohl das zweite als auch das dritte Ausführungsbeispiel von Halbleiterbauelementen 100 weisen jeweils eine Vielzahl an Feldplatten-Trench-FETs 50, 49 auf, von welchen je Ausführungsbeispiel jeweils vier dargestellt sind. In dem links in Figur 2 dargestellten zweiten Ausführungsbeispiel sind die Feldplatten-Trench-FETs 50, 49 innerhalb einer Reihe 99 angeordnet, wobei auf jeweils zwei Feldpiatten-Trench-FETs des Standes der Technik 49 ein ausgeführter Feldplatten-Trench-FET 50 folgt. In dem links in Figur 2 dargestellten zweiten Ausführungsbeispiel handelt es sich bei dem zweiten und dritten Transistor, von links ausgehend betrachtet, um Feldplatten-Trench-FETs des Standes der Technik 49, während es sich bei dem ersten und vierten Transistor, von links ausgehend betrachtet, um Feldplatten-Trench-FETs 50 handelt, weiche also jeweils ein p-dotiertes Gebiet 2 unterhalb ihres jeweiligen Grabens 10 aufweisen.

Im Gegensatz dazu ist bei dem rechts in Figur 2 dargestellten dritten Ausführungsbeispiel eines Halbleiterbauelementes 100 jeder Transistor als unterschiedlich ausgeführter Feldplatten-Trench-FET 50 realisiert. Mit anderen Worten ausgedrückt, ist rechts in Figur 2 unter jedem Feldplatten-Trench-FET 50 ein p-dotiertes Gebiet 2 vorgesehen.

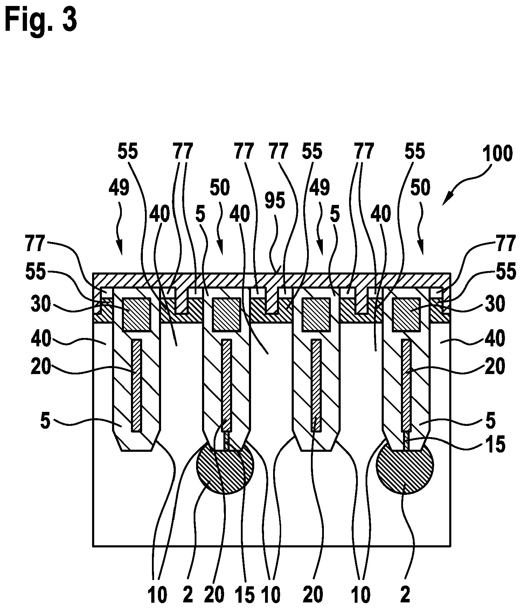

In der Figur 3 ist ein viertes Ausführungsbeispiel eines Halbleiterbauelementes 100 dargestellt, bei welchem es sich im Wesentlichen um das in Figur 1 rechts dargestellte erste Ausführungsbeispiel eines Halbleiterbauelementes 100 handelt. Die gleich bezeichneten Komponenten in der Figur 3 entsprechen also jenen des rechts in Figur 1 gezeigten ersten Ausführungsbeispiels, sodass das dort Beschriebene bezüglich dieser Komponenten auch auf das vierte Ausführungsbeispiel der Figur 3 zu übertragen ist. Der wesentliche Unterschied zwischen dem vierten Ausführungsbeispiel der Figur 3 und dem rechts in Figur 1 dargestellten ersten Ausführungsbeispiel ist, dass die p-dotierten Gebiete 2 der ausgeführten Feldplatten-Trench-FETs 50 jeweils elektrisch leitfähig mit der Feldplatte 20 ihres jeweiligen Feldplatten-Trench-FETs 50 verbunden sind. Mit anderen Worten ausgedrückt, sind die p-dotierten Gebiete 2 der ausgeführten Feldplatten-Trench-FETs 50 im vierten Ausführungsbeispiel eines Halbleiterbauelementes 100 jeweils mit dem elektrischen Potenzial ihrer jeweiligen Feldplatte 20 verbunden. Dabei sind die p-dotierten Gebiete 2 der jeweiligen Feldplatten-Trench-FETs 50 in diesem vierten Ausführungsbeispiel jeweils rein beispielhaft über einen elektrisch leitfähigen Pfad 15 durch den innerhalb des jeweils zugehörigen Grabens 10 befindlichen Isolator 5 mit der jeweiligen Feldplatte 20 elektrisch leitfähig verbunden. Mit anderen Worten ausgedrückt, sind die p-dotierten Gebiete 2 unterhalb der ausgeführten Feldplatten-Trench-FETs 50 über eine schmale elektrisch leitfähige Verbindung mit den Feldplatten 20 ihrer jeweiligen Feldplatten-Trench-FETs 50 elektrisch leitfähig verbunden. Ferner sind die Feldplatten-Trench-FETs 50 in diesem vierten Ausführungsbeispiel rein beispielhaft als Feldplatten-Trench-MOSFETs 50 ausgeführt.

Die p-dotierten Gebiete 2 unterhalb der Feldplatten-Trench-FETs 50 müssen nicht vollständig entlang des Grabens 10 ihres jeweils zugehörigen erfindungsgemäßen Feldplatten-Trench-FETs 50 verlaufen, sondern können im Allgemeinen an beliebigen Stellen entlang des Grabens 10 beliebig lange Unterbrechungen aufweisen.

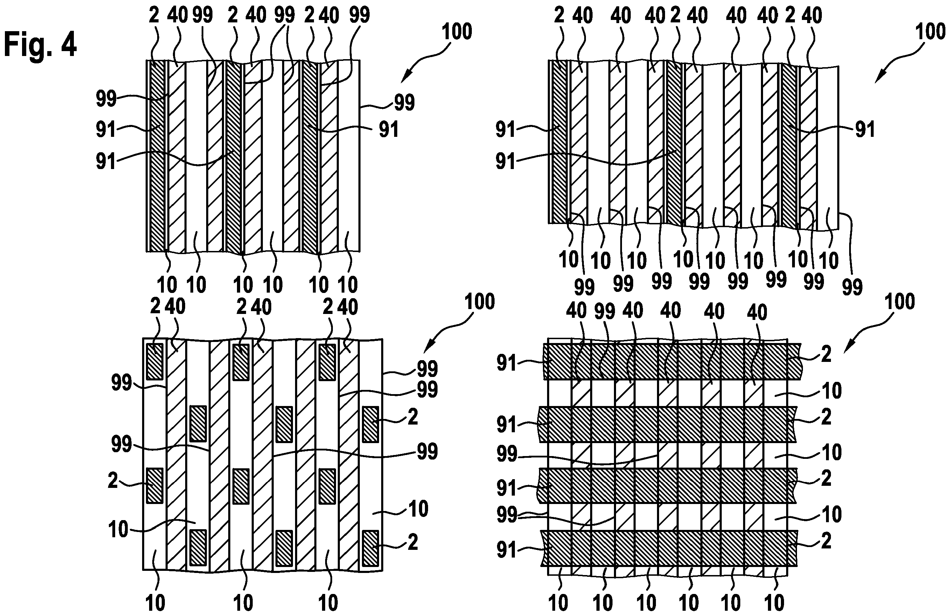

Figur 4 zeigt drei verschiedene schematisch dargestellte Beispiele, die nicht Bestandteil der Erfindung sind, sowie ein Ausführungsbeispiel eines Layouts für die Anordnung von Feldplatten-Trench-FETs 50, 49 innerhalb erfindungsgemäß ausgeführter Halbleiterbauelemente 100 in einer Draufsicht. Bei diesen sind der Übersichtlichkeit halber lediglich die im Substrat 40 gebildeten Gräben 10 der Feldplatten-Trench-FETs 50, 49 sowie die p-dotierten Gebiete 2 der erfindungsgemäß ausgeführten Feldplatten-Trench-FETs 50 in Ausschnitten der erfindungsgemäßen Halbleiterbauelemente 100 in einer Draufsicht dargestellt. Die Gräben 10 der Feldplatten-Trench-FETs 50, 49 sind dabei in Figur 4 hell dargestellt, während die p-dotierten Gebiete 2 dunkel dargestellt sind. In dieser Figur 4 sowie in den folgenden Figuren sind die p-dotierten Gebiete 2 nicht maßstabsgetreu abgebildet In Realität können die p-dotierten Gebiete 2 innerhalb erfindungsgemäßer Halbleiterbauelemente 100 in ihren Abmessungen beziehungsweise in ihrer Ausdehnung wesentlich von der Darstellung abweichen.

Oben links in Figur 4 ist ein Ausschnitt aus einem fünften Beispiel, das nicht Bestandteil der Erfindung ist, eines Halbleiterbauelementes 100 gezeigt, bei welchem Feldplatten-Trench-FETs 50, 49 in einer Vielzahl zueinander paralleler Reihen 99 jeweils aufeinander folgend angeordnet sind. Die Feldplatten-Trench-FETs 50, 49 sind in dem oben links in Figur 4 dargestellten fünften Beispiel also jeweils nebeneinander in mehreren Reihen 99 angeordnet, von welchen oben links in Figur 4 sechs dargestellt sind. Dabei umfasst die erste Reihe 99, von links ausgehend betrachtet, rein beispielhaft lediglich Feldplatten-Trench-FETs 50, von welchen lediglich die Gräben 10 sowie die unterhalb der Gräben 10 angeordneten p-dotierten Gebiete 2 dargestellt sind. Die p-dotierten Gebiete 2 unterhalb der Feldplatten-Trench FETs 50 sind in diesem fünften Beispiel rein beispielhaft miteinander zu einem sich innerhalb des Substrates 40 des Halbleiterbauelementes 100 erstreckenden Streifen 91 verbunden. Die zweite Reihe 99, von links ausgehend betrachtet, umfasst in diesem fünften Ausführungsbeispiel rein beispielhaft lediglich Feldplatten-Trench-FETs des Standes der Technik 49. Die dritte Reihe 99, von links ausgehend betrachtet, ist wiederum wie die erste Reihe 99, von links ausgehend betrachtet, ausgeführt, während die vierte Reihe 99, von links ausgehend betrachtet, wieder wie die zweite Reihe 99, von links ausgehend betrachtet, ausgeführt ist. Dieses Anordnungsmuster setzt sich über das gesamte fünfte Beispiel eines Halbleiterbauelementes 100 fort. Mit anderen Worten ausgedrückt, folgt in diesem fünften Beispiel auf jeweils eine Reihe 99 ausgeführter Feldplatten-Trench-FETs 50 stets eine Reihe 99 aus Feldplatten-Trench-FETs des Standes der Technik 49 und umgekehrt.

Bei dem oben rechts in Figur 4 dargestellten sechsten Beispiel, das nicht Bestandteil der Erfindung ist, eines Halbleiterbauelementes 100 handelt es sich im Wesentlichen um das oben links in Figur 4 dargestellte fünfte Beispiel, wobei im Unterschied zu dem fünften Beispiel bei diesem sechsten Beispie! auf jeweils zwei nebeneinander angeordnete Reihen 99 aus jeweils nebeneinander angeordneten Feldplatten-Trench-FETs des Standes der Technik 49 jeweils eine Reihe 99 aus nebeneinander angeordneten Feldplatten-Trench-FETs 50 folgt.

Auch bei dem unten links in Figur 4 dargestellten siebten Beispiel, das nicht Bestandteil der Erfindung ist, eines Halbleiterbauelementes 100 handelt es sich im Wesentlichen um das oben links in Figur 4 dargestellte fünfte Beispiel, wobei im Unterschied zu dem fünften Beispiel bei diesem siebten Beispiel in jeder Reihe 99 ausgeführte Feldplatten-Trench-FETs 50 vorgesehen sind, wobei innerhalb der Reihen 99 auf jeweils rein beispielhaft drei aufeinanderfolgende ausgeführte Feldplatten-Trench-FETs 50 mit miteinander verbundenen p-dotierten Gebieten 2 jeweils eine Vielzahl an Feldplatten-Trench-FETs des Standes der Technik 49 folgen. Mit anderen Worten ausgedrückt, weist das entlang der Gräben 10 der Feldplatten-Trench-FETs 50, 49 verlaufende p-dotierte Gebiet 2 Unterbrechungen auf.

Bei dem unten rechts in Figur 4 dargestellten achten Ausführungsbeispiel sind mehrere Feldplatten-Trench-FETs 49 des Standes der Technik umfassende Reihen 99 zueinander parallel angeordnet, wobei innerhalb der Reihen 99 auf jeweils gleicher Höhe, das heißt Reihen 99 übergreifend horizontal nebeneinander, erfindungsgemäße Feldplatten-Trench-FETs 50 vorgesehen sind, deren p-dotierte Gebiete 2 jeweils miteinander verbunden sind und dadurch sich horizontal erstreckende, zu den Reihen 99 orthogonale Streifen 91 bilden.

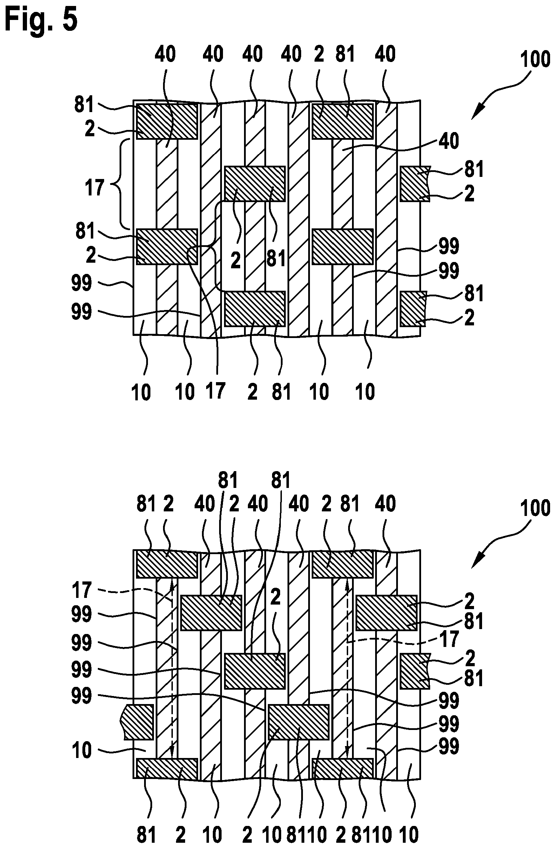

In Figur 5 sind zwei weitere schematisch dargestellte Ausführungsbeispiele von Layouts für die Anordnung von Feldplatten-Trench-FETs 50, 49 innerhalb erfindungsgemäß ausgeführter Halbleiterbauelemente 100 in einer Draufsicht dargestellt.

Auch bei diesen sind der Übersichtlichkeit halber lediglich die im Substrat 40 gebildeten Gräben 10 der Feldplatten-Trench-FETs 50, 49 sowie die p-dotierten Gebiete 2 der erfindungsgemäß ausgeführten Feldplatten-Trench-FETs 50 in Ausschnitten der erfindungsgemäßen Halbleiterbauelemente 100 in einer Draufsicht dargestellt. Die Gräben 10 der Feldplatten-Trench-FETs 50, 49 sind dabei in Figur 5 hell dargestellt, während die p-dotierten Gebiete 2 dunkel dargestellt sind. Sowohl im oben in Figur 5 dargestellten neunten Ausführungsbeispie! eines erfindungsgemäßen Halbleiterbauelementes 100 als auch im unten in Figur 5 dargestellten zehnten Ausführungsbeispiel eines erfindungsgemäßen Halbleiterbauelementes 100 sind mehrere Reihen 99 aus neben- beziehungsweise übereinander angeordneten Feldplatten-Trench-FETs des Standes der Technik 49 vorgesehen, welche zueinander parallel angeordnet sind.

In dem oben und unten in Figur 5 dargestellten neunten beziehungsweise zehnten Ausführungsbeispiel sind entlang jeweils zweier benachbarter Reihen 99 in jeweils vorbestimmten beziehungsweise vordefinierten und konstanten vertikalen Abständen 17 zueinander jeweils die benachbarten Transistoren dieser zwei Reihen 99 als erfindungsgemäße Feldplatten-Trench-FETs 50 ausgeführt, deren p-dotierten Gebiete 2 jeweils miteinander verbunden sind. Mit anderen Worten ausgedrückt, sind im neunten und zehnten Ausführungsbeispiel bei jeweils zwei zueinander direkt benachbarten Reihen 99 in vertikal vorbestimmten Abständen 17 zueinander innerhalb dieser benachbarten Reihen 99 die benachbarten Transistoren dieser beiden Reihen 99 als erfindungsgemäße Feldplatten-Trench-FETs 50 ausgeführt, deren p-dotierte Gebiete 2 jeweils eine Brücke 81 zwischen den jeweils zueinander direkt benachbart angeordneten Reihen 99 bilden. Im oben in Figur 5 dargestellten neunten Ausführungsbeispiel sind die p-dotierten Gebiete 2 beziehungsweise die durch selbige gebildeten Brücken 81 von Reihenpaar zu Reihenpaar zueinander vertikal versetzt angeordnet, wobei ein Reihenpaar aus zwei direkt benachbarten Reihen 99 gebildet wird, und wobei die p-dotierten Gebiete 2 beziehungsweise Brücken 81 jeweils zweier übernächster Reihenpaare jeweils auf gleicher Höhe liegen, also jeweils von einer gedachten, zu den Reihen 99 orthogonalen Linie durchkreuzt werden, Im unten in Figur 5 dargestellten zehnten Ausführungsbeispiel sind die Brücken 81 aus den p-dotierten Gebieten 2 und damit die erfindungsgemäßen Feldplatten-Trench-FETs 50 von Reihenpaar zu Reihenpaar so angeordnet, dass die Brücken 81, also die p-dotierten Gebiete 2 von Reihe 99 zu Reihe 99 eine Treppenform bilden.

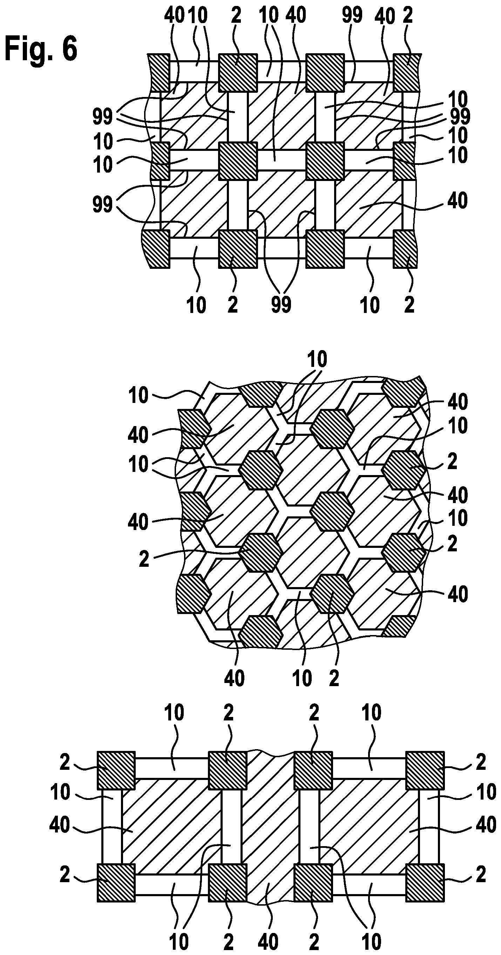

In Figur 6 sind drei weitere schematisch dargestellte Ausführungsbeispiele von Layouts für die Anordnung von Feldplatten-Trench-FETs 50, 49 innerhalb ausgeführter Halbleiterbauelemente 100 in einer Draufsicht dargestellt. Auch bei diesen sind der Übersichtlichkeit halber lediglich die im Substrat 40 gebildeten Gräben 10 der Feldplatten-Trench-FETs 50, 49 sowie die p-dotierten Gebiete 2 der ausgeführten Feldplatten-Trench-FETs 50 in Ausschnitten der Halbleiterbauelemente 100 in einer Draufsicht dargestellt. Die Gräben 10 der Feldplatten-Trench-FETs 50, 49 sind dabei in Figur 6 hell dargestellt, während die p-dotierten Gebiete 2 dunkel dargestellt sind. In dem oben in Figur 6 dargestellten elften Ausführungsbeispiel bilden die horizontal und vertikal sowie zueinander orthogonal verlaufenden Gräben 10 der Feldplatten-Trench-FETs 50, 49 ein Matrix-Muster beziehungsweise eine Rechtecke aufweisende Gitternetzstruktur. Jeweils an den Kreuzungspunkten der orthogonal zueinander verlaufenden Gräben 10 sind viereckig ausgeführte p-dotierte Gebiete 2 von Feldplatten-Trench-FETs 50 des Halbleiterbauelementes 100 vorgesehen. In dem mittig in Figur 6 dargestellten zwölften Ausführungsbeispiel bilden die Gräben 10 der Feldplatten-Trench-FETs 50, 49 eine wabenförmige Struktur, welche miteinander verbundene, sechseckige Waben aufweist, wobei an je Wabe jeweils drei Verbindungspunkten der Waben miteinander jeweils ein ebenfalls sechseckig ausgeführtes p-dotiertes Gebiet 2 von Feldplatten-Trench-FETs 50 des Halbleiterbauelementes 100 vorgesehen ist. In dem unten in Figur 6 dargestellten dreizehnten Ausführungsbeispiel verlaufen die Gräben 10 der Feldplatten-Trench-FETs 50, 49 des Halbleiterbauelementes 100 in überschneidungsfreien Vierecken, an deren Eckpunkten ebenfalls viereckig ausgeführte p-dotierte Gebiete 2 von Feldplatten-Trench-FETs 50 des erfindungsgemäßen Halbleiterbauelementes 100 angeordnet sind.

In allen zuvor beschriebenen Ausführungsbeispielen können anstelle von Feldplatten-Trench-FETs des Standes der Technik 49 auch lediglich Trench-FETs des Standes der Technik 49, also Trench-FETs des Standes der Technik 49 ohne eine Feldplatte 20 vorgesehen sein. In den in den Figuren 4 bis 6 gezeigten Halbleiterbauelementen 100 sind weder die Abmessungen beziehungsweise Ausdehnungen der Gräben 10 noch die Abmessungen beziehungsweise Ausdehnungen der p-dotierten Gebiete 2 maßstabsgetreu. Es können also auch erfindungsgemäße Halbleiterbauelemente 100 ausgeführt werden, bei welchen die p-dotierten Gebiete 2 erfindungsgemäßer Feldplatten-Trench-FETs 50 innerhalb erfindungsgemäßer Halbleiterbauelemente 100 breiter als die Gräben 10 sind.

Ferner kann das Substrat 40 in allen dargestellten beziehungsweise beschriebenen Ausführungsbeispielen von erfindungsgemäßen Halbleiterbauelementen 100 auch als Halbleiterschicht ausgeführt sein. Ferner können erfindungsgemäße Halbleiterbauelemente 100 ausgeführt sein, bei welchen unterhalb einer solchen Halbleiterschicht optional ein weiteres Substrat 40 angeordnet ist. Dieses weitere Substrat 40 kann rein beispielhaft hochdotiert sein. Es können also auch erfindungsgemäße Halbleiterbauelemente 100 ausgeführt werden, welche rein beispielhaft in einem Chip beziehungsweise innerhalb des hochdotierten Trägersubstrates eines solchen Chips realisiert sind. Ferner können aber auch erfindungsgemäße Halbleiterbauelemente 100 ausgeführt werden, welche rein beispielhaft auf einem Dünnwafer oder aber auch auf einem beliebigen anderen Träger realisiert sind. Solche Dünnwafer können ferner rein beispielhaft ausschließlich eine niedrig dotierte Halbleiterschicht umfassen, in welcher erfindungsgemäße Feldplatten-Trench-FETs 50 realisiert sind. Ferner können auch erfindungsgemäße Halbleiterbauelemente 100 mit erfindungsgemäßen Feldplatten-Trench-FETs 50 ausgeführt werden, welche p-dotierte-Gebiete 2 mit einem von der hier gewählten Darstellung und Beschreibung abweichenden Querschnitt aufweisen. Beispielsweise kann der Querschnitt der p-dotierten Gebiete 2 erfindungsgemäßer Feldplatten-Trench-FETs 50 auch abgerundet oder kreisförmig sein.

## Patentansprüche

1. Halbleiterbauelement (100), umfassend
- ein Substrat (40)
- eine Vielzahl an innerhalb des Substrates (40) angeordnete Feldplatten-Trench-FETs (50),
- mindestens einen Trench-FET (49), welcher ein Substrat (40) sowie zumindest ein teilweise innerhalb des Substrates (40) vergrabenes Gate (30) umfasst, wobei das Gate (30) innerhalb eines Grabens (10) angeordnet und von einem Isolator (5) umschlossen ist,
wobei die Feldplatten-Trench-FETs (50) umfassen:
- ein zumindest teilweise innerhalb des Substrates (40) vergrabenes Gate (30),
- eine unterhalb des Gates (30) angeordnete Feldplatte (20), wobei sowohl das Gate (30) als auch die Feldplatte (20) innerhalb eines Grabens (10) im Substrat (40) angeordnet und von einem Isolator (5) umschlossen sind, wobei unterhalb des Grabens (10) ein p-dotiertes Gebiet (2) innerhalb des Substrats (40) angeordnet ist,
wobei das p-dotierte Gebiet (2) elektrisch leitfähig mit der Feldplatte (20) verbunden ist, wobei das p-dotierte Gebiet (2) über einen elektrisch leitfähigen Pfad (15) durch den innerhalb des Grabens (10) befindlichen Isolator (5) mit der Feldplatte (20) elektrisch leitfähig verbunden ist **dadurch gekennzeichnet, dass** Reihen (99) aus vertikal und zueinander parallel angeordneten Trench-FETs (49) bestehen, wobei innerhalb der Reihen (99) mehrere Reihen von auf jeweils gleicher Höhe, wobei die Reihen (99) übergreifend horizontal nebeneinander angeordnet sind, Feldplatten-Trench-FETs (50) vorgesehen sind, wobei zumindest einige ihrer p-dotierten Gebiete (2) jeweils miteinander verbunden sind und dadurch sich horizontal erstreckende, zu den Reihen (99) orthogonale Streifen (91) bilden.

2. Halbleiterbauelement (100) nach Anspruch 1, mit einer Vielzahl von Trench-FETs (49), wobei jeweils ein Trench-FET (49) direkt neben einem Feldplatten-Trench-FET (50) nach Anspruch 1 angeordnet ist.

3. Halbleiterbauelement (100) nach Anspruch 1 oder 2, wobei mindestens einer der Trench-FETs (49) eine innerhalb seines jeweiligen Grabens (10) angeordnete Feldplatte (20) aufweist und als Feldplatten-Trench-FET (49) ausgeführt ist.

4. Halbleiterbauelement (100) nach einem der Ansprüche 1 bis 3,
wobei ein Feldplatten-Trench-FET (50) als Feldplatten-Trench-MOSFET ausgeführt ist.

## Claims

1. Semiconductor component (100), comprising
- a substrate (40),
- a multiplicity of field plate trench FETs (50) arranged within the substrate (40),
- at least one trench FET (49) comprising a substrate (40) and also at least one gate (30) buried partly within the substrate (40), wherein the gate (30) is arranged within a trench (10) and enclosed by an insulator (5),
wherein the field plate trench FETs (50) comprise:
- a gate (30) buried at least partly within the substrate (40),
- a field plate (20) arranged below the gate (30), wherein both the gate (30) and the field plate (20) are arranged within a trench (10) in the substrate (40) and are enclosed by an insulator (5),
wherein a p-doped region (2) is arranged within the substrate (40) below the trench (10),
wherein the p-doped region (2) is electrically conductively connected to the field plate (20), wherein the p-doped region (2) is electrically conductively connected to the field plate (20) via an electrically conductive path (15) through the insulator (5) situated within the trench (10),
**characterized in that**
rows (99) consist of trench FETs (49) arranged vertically and parallel to one another, wherein within the rows (99) there are provided a plurality of rows of field plate trench FETs (50) at the same level in each case, wherein the rows (99) are arranged horizontally next to one another throughout, wherein at least some of the p-doped regions (2) of said field plate trench FETs are in each case connected to one another and thereby form horizontally extending strips (91) orthogonal to the rows (99).

2. Semiconductor component (100) according to Claim 1, having a multiplicity of trench FETs (49), wherein each trench FET (49) is arranged directly next to a field plate trench FET (50) according to Claim 1.

3. Semiconductor component (100) according to Claim 1 or 2, wherein at least one of the trench FETs (49) has a field plate (20) arranged within its respective trench (10) and is embodied as a field plate trench FET (49).

4. Semiconductor component (100) according to any of Claims 1 to 3, wherein a field plate trench FET (50) is embodied as a field plate trench MOSFET.

## Revendications

1. Dispositif à semi-conducteur (100), comprenant
- un substrat (40),
- une pluralité de FET à plaques de champ et à tranchées (50) disposés à l'intérieur du substrat (40),
- au moins un FET à tranchées (49) qui comprend un substrat (40) ainsi qu'au moins une grille (30) noyée au moins partiellement à l'intérieur du substrat (40), la grille (30) étant disposée à l'intérieur d'une tranchée (10) et entourée d'un isolant (5),
les FET à plaques de champ et à tranchées (50) comprenant :
- une grille (30) au moins partiellement noyée à l'intérieur du substrat (40),
- une plaque de champ (20) disposée au-dessous de la grille (30), à la fois la grille (30) et la plaque de champ (20) étant disposées à l'intérieur d'une tranchée (10) dans le substrat (40) et entourées d'un isolant (5),
une région dopée p (2) étant disposée au-dessous de la tranchée (10) à l'intérieur du substrat (40),
la région dopée p (2) étant reliée de manière électriquement conductrice à la plaque de champ (20), la région dopée p (2) étant reliée de manière électriquement conductrice à la plaque de champ (20) par un trajet électriquement conducteur (15) à travers l'isolant (5) se trouvant à l'intérieur de la tranchée (10) ,
**caractérisé en ce que** des rangées (99) sont composées de FET à tranchées (49) disposés verticalement et en parallèle les uns aux autres, dans lequel, dans lequel, parmi les rangées (99), les rangées (99) étant disposées horizontalement côte à côte en chevauchement, plusieurs rangées de FET à plaques de champ et à tranchées (50) à la même hauteur respectivement sont prévues, dans lequel au moins certaines de leurs régions dopées p (2) sont respectivement reliées les unes aux autres et forment ainsi des bandes orthogonales (91) aux rangées (99) s'étendant horizontalement.

2. Dispositif à semi-conducteur (100) selon la revendication 1, comprenant une pluralité de FET à tranchées (49), respectivement un FET à tranchées (49) étant disposé directement à côté d'un FET à plaques de champ et à tranchées (50) selon la revendication 1.

3. Dispositif à semi-conducteur (100) selon la revendication 1 ou 2, dans lequel au moins l'un des FET à tranchées (49) présente une plaque de champ (20) disposée à l'intérieur de sa tranchée respective (10) et est configuré sous la forme d'un FET à plaques de champ et à tranchées (49).

4. Dispositif à semi-conducteur (100) selon l'une quelconque des revendications 1 à 3, dans lequel un FET à plaque de champ et à tranchées (50) est réalisé sous la forme d'un MOSFET à plaques de champ et à tranchées.
